# DEMANDE DE BREVET EUROPEEN

(11) **EP 4 707 507 A1**
(43) Date de publication de la demande: **11.03.2026**
(21) Numéro de dépôt: 25200354.6
(22) Date de dépôt: 04.09.2025
(51) Int. Cl.: E05B 65/00

(54) **DISPOSITIF DE VERROUILLAGE D'UN ENSEMBLE DE CAPOT**

(30) Priorité: 06.09.2024 FR 2409467
(71) Demandeur: SAGEMCOM ENERGY & TELECOM SAS, 92270 Bois-Colombes (FR)
(72) Inventeur: BROSSARD, Matthieu, 92270 Bois-Colombes (FR); CHEVROT, Charles, 92270 Bois-Colombes (FR)
(74) Mandataire: Novagraaf Technologies

(57) **Abrégé**

La présente invention a pour objet un ensemble de capot (10) comprenant une paroi principale (12) et un couvercle (14), aptes à coopérer l'un avec l'autre, l'ensemble de capot (10) comprenant un dispositif de verrouillage (16) configuré pour bloquer en position le couvercle (14) sur la paroi principale (12), le dispositif de verrouillage (16) comprenant au moins :
- Un actionneur (18) sur la paroi principale (12) et comprenant au moins une nervure d'actionnement et au moins un organe déformable élastiquement,
- Un organe de blocage s'étendant en saillie depuis le couvercle (14) et configuré au moins pour bloquer en position ledit couvercle (14) par rapport à la paroi principale (12).

## Description

### Domaine technique de l'invention

La présente invention concerne un ensemble de capot comprenant un dispositif de verrouillage apte à solidariser un couvercle sur une paroi principale.

### Arrière-plan technique

Lorsque deux pièces doivent être solidaires l'une de l'autre, il est courant d'utiliser une pièce tierce indépendantes des pièces à solidariser, telle qu'une vis, pour les maintenir en position l'une par rapport à l'autre.

Par exemple, dans le domaine des installations de compteurs électriques, il est courant qu'un couvercle, ou couvre borne, soit solidaire d'un capot via un vis, par exemple une vis à quart de tour. En l'espèce, un utilisateur doit positionner le couvercle en recouvrement du capot puis doit opérer une opération de vissage ou de rotation d'un quart de tour de la vis. Ainsi, lorsqu'un utilisateur souhaite désolidariser le couvercle du capot il doit au préalable dévisser la vis puis décrocher le couvercle du capot.

Le but de la présente invention est de proposer une alternative aux solutions de solidarisation de deux pièces l'une avec l'autre existantes, par exemple dans le cadre d'une installation de compteur électrique, en n'utilisant pas de pièce tierce indépendante.

L'invention se propose ainsi de réduire la complexité de l'assemblage entre deux pièces, en concevant un dispositif de verrouillage directement intégré aux pièces à solidariser l'une à l'autre.

### Résumé de l'invention

L'invention propose un ensemble de capot comprenant une paroi principale et un couvercle, aptes à coopérer l'un avec l'autre, l'ensemble de capot comprenant un dispositif de verrouillage configuré pour bloquer en position le couvercle sur la paroi principale, le dispositif de verrouillage comprenant au moins :
- Un actionneur sur la paroi principale et comprenant au moins une nervure d'actionnement et au moins un organe déformable élastiquement liés en translation l'un à l'autre,
   la nervure d'actionnement s'étendant au travers d'une lumière traversante formée dans la paroi principale, et
   l'actionneur étant mobile en translation par rapport à la paroi principale de manière que la nervure d'actionnement se déplace au travers de la lumière entre une position de fermeture du dispositif de verrouillage dans laquelle l'organe déformable élastiquement est dans un état de décompression, et une position d'ouverture du dispositif de verrouillage dans laquelle l'organe déformable élastiquement est dans un état de compression,
- Un organe de blocage s'étendant en saillie depuis le couvercle et configuré au moins pour bloquer en position ledit couvercle par rapport à la paroi principale lorsque la nervure d'actionnement de l'actionneur est dans la position de fermeture du dispositif de verrouillage.

Selon d'autres caractéristiques de l'invention :
- l'actionneur comprend une lame depuis laquelle la nervure d'actionnement s'étend en saillie, la lame étant solidaire de l'organe déformable élastiquement par au moins un bras de maintien s'étendant transversalement depuis la lame, le ressort étant solidaire du bras de maintien ;
- au moins deux organes de maintien s'étendent en saillie depuis la paroi principale et de manière à bloquer en position l'actionneur contre la paroi principale et de manière à autoriser le déplacement en translation de l'actionneur par rapport à la paroi principale ;
- la paroi principale comprend un alésage traversant configuré de manière à recevoir l'organe de blocage ;
- l'organe de blocage comprend au moins une tranche de guidage s'étendant dans un plan sécant d'un plan commun de l'actionneur, l'au moins une tranche de guidage étant configurée pour déplacer la nervure d'actionnement depuis la position de fermeture du dispositif de verrouillage vers la position d'ouverture du dispositif de verrouillage lors de l'insertion de l'organe de blocage dans l'alésage ;
- l'organe de blocage comprend au moins une tranche de retenue configurée pour déplacer automatiquement la nervure d'actionnement depuis la position d'ouverture du dispositif de verrouillage vers la position de fermeture du dispositif de verrouillage lors de l'insertion de l'organe de blocage dans l'alésage, de manière à bloquer en position le couvercle par rapport à la paroi principale ;
- la lame comprend un bord biseauté configurée pour être en contact plan avec l'au moins une tranche de guidage de l'organe de blocage lors de l'insertion de l'organe de blocage dans l'alésage ;
- l'organe de blocage comprend au moins une tranche de contact configurée pour être en contact plan avec le bord biseauté de la lame lorsque l'organe de blocage est inséré dans l'alésage et que la nervure d'actionnement dans la position de fermeture du dispositif de verrouillage ;
- le couvercle comprend une lumière complémentaire configurée pour s'étendre en regard de la lumière de la paroi principale lorsque le couvercle est assemblé sur la paroi principale et de manière que la nervure d'actionnement s'étende au travers de la lumière complémentaire ;
- l'actionneur est monté pivotant par rapport à la paroi principale au moyen d'au moins une charnière élastique s'étendant entre l'au moins un organe déformable élastiquement et la paroi principale, et de manière que l'actionneur soit apte à pivoter autour d'un axe de charnière par rapport à la paroi principale ;
- l'actionneur est monobloc avec la paroi principale et l'organe de blocage est monobloc avec le couvercle ;
- l'ensemble de capot est obtenu par un procédé d'injection plastique.

L'invention porte également sur une installation de compteur électrique comprenant un compteur électrique est au moins un ensemble de capot selon l'une quelconque des caractéristiques précédentes.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig.1a] est une vue générale en perspective d'une installation de compteur électrique comprenant un ensemble de capot composé d'une paroi principale, d'un couvercle et d'un dispositif de verrouillage ;
[Fig.1b] est une vue générale en éclatée de l'installation de compteur électrique de la figure 1a montrant le couvercle désolidarisé de la paroi principale ;
[Fig.2] est une vue schématique en perspective de la paroi principale de l'ensemble de capot de la figure 1a et d'un actionneur du dispositif de verrouillage de la figure 1a formé sur la paroi principale, le dispositif de verrouillage comprenant au moins un ressort représenté dans un état décompressé ;
[Fig.3] est une vue schématique en perspective de la paroi principale de l'ensemble de capot de la figure 1a et de l'actionneur du dispositif de verrouillage de la figure 1b formé sur la paroi principale, le dispositif de verrouillage comprenant au moins le ressort représenté dans un état compressé ;
[Fig.4] est une vue schématique en perspective d'une face extérieure de la paroi principale de la figure 1a montrant une nervure d'actionnement de l'actionneur qui s'étend en saillie dans une lumière de la paroi principale ;
[Fig.5] est une vue schématique de face de la face extérieure de la paroi principale de la figure 1a montrant la nervure d'actionnement de l'actionneur qui s'étend en saillie dans la lumière de la paroi principale, et montrant un alésage traversant de la paroi principale en forme de U ;
[Fig.6] est une vue schématique en perspective du couvercle de la figure 1a comprenant un organe de blocage du dispositif de verrouillage de la figure 1a et une lumière complémentaire ;
[Fig.7] est une vue schématique de côté du couvercle de la figure 6 ;
[Fig.8] est une vue schématique en perspective du couvercle assemblé sur la paroi principale au moyen du dispositif de verrouillage ;
[Fig.9] est une vue schématique en perspective de la paroi principale sur laquelle est formé l'actionneur du dispositif de verrouillage dans une position relevée, à l'issue d'un procédé de fabrication par injection plastique ;
[Fig.10a] est une vue schématique en perspective de la paroi principale de l'ensemble de capot de la figure 1a et de l'actionneur du dispositif de verrouillage de la figure 1a formé sur la paroi principale, le dispositif de verrouillage comprenant deux ressorts représentés dans un état décompressé ;
[Fig.10b] est une vue schématique de face de la face extérieure de la paroi principale montrant la nervure d'actionnement s'étendant au travers de la lumière de la paroi principal dans une position de fermeture du dispositif de verrouillage et l'alésage en forme de U ;
[Fig.11a] est une vue schématique en coupe longitudinale et verticale de l'ensemble de capot de la figure 1a montrant l'organe de blocage durant son insertion dans l'alésage en forme de U de la paroi principale ;
[Fig.11b] est une vue schématique de face de la face extérieure de la paroi principale et du couvercle, montrant la nervure d'actionnement s'étendant au travers de la lumière et de la lumière complémentaire de la paroi principal et du couvercle, la nervure d'actionnement étant dans une position de fermeture du dispositif de verrouillage ;
[Fig.12a] est une vue schématique en coupe longitudinale et verticale de l'ensemble de capot de la figure 1a montrant l'organe de blocage durant son insertion dans l'alésage en forme de U de la paroi principale ;
[Fig.12b] est une vue schématique de face de la face extérieure de la paroi principale et du couvercle, montrant la nervure d'actionnement s'étendant au travers de la lumière et de la lumière complémentaire de la paroi principal et du couvercle, la nervure d'actionnement étant dans une position d'ouverture du dispositif de verrouillage ;
[Fig.13a] est une vue schématique en coupe longitudinale et verticale de l'ensemble de capot de la figure 1a montrant l'organe de blocage bloqué en position par l'actionneur dans l'alésage en forme de U de la paroi principale ;
[Fig.13b] est une vue schématique de face de la face extérieure de la paroi principale et du couvercle, montrant la nervure d'actionnement s'étendant au travers de la lumière et de la lumière complémentaire de la paroi principal et du couvercle, la nervure d'actionnement étant dans la position de fermeture du dispositif de verrouillage.

### Description détaillée de l'invention

Dans la description qui va suivre, des éléments identiques, similaires ou analogues seront désignés par les mêmes chiffres de référence.

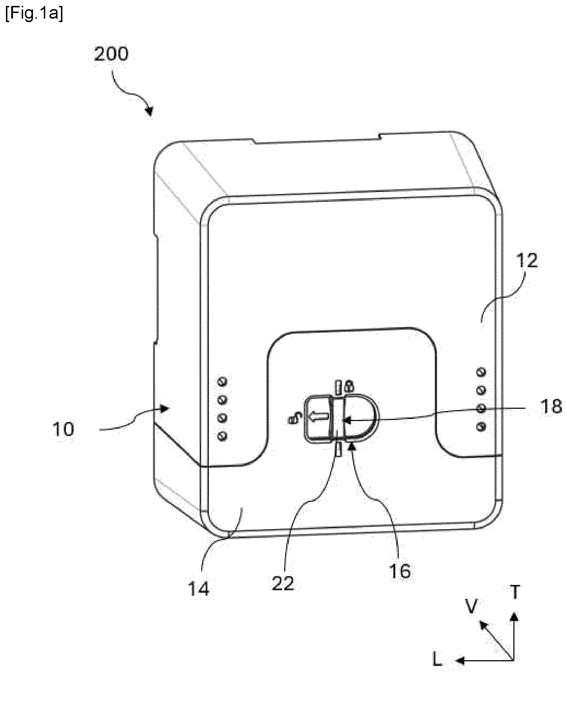

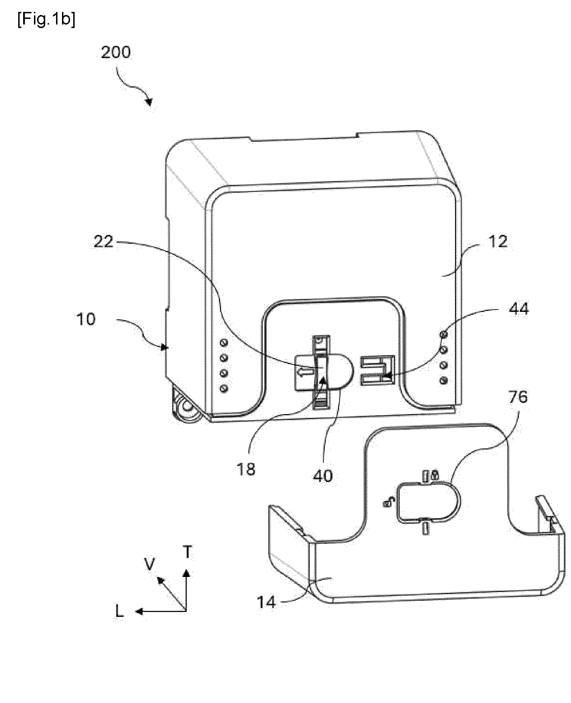

Les figures 1a et 1b illustrent un ensemble de capot 10 composé d'une paroi principale 12 et d'un couvercle 12 qui sont aptes à coopérer l'un avec l'autre et bloqués en position l'un par rapport à l'autre au moyen d'un dispositif de verrouillage 16 de l'ensemble de capot 10.

De manière plus précise, le dispositif de verrouillage 16 est configuré pour bloquer en position le couvercle 14 sur la paroi principale 12.

A titre d'exemple non limitatif, l'ensemble de capot 10 est ici constitutif d'une installation de compteur électrique 200 dont la paroi principale 12 peut former un capot du compteur électrique et le couvercle 14 peut être un couvre borne de ce capot du compteur électrique, disposé au moins en partie en recouvrement de la paroi principale 12.

L'ensemble de capot 10 est ainsi configuré pour isoler, au moins visuellement, l'installation de compteur électrique 200 de l'environnement extérieur.

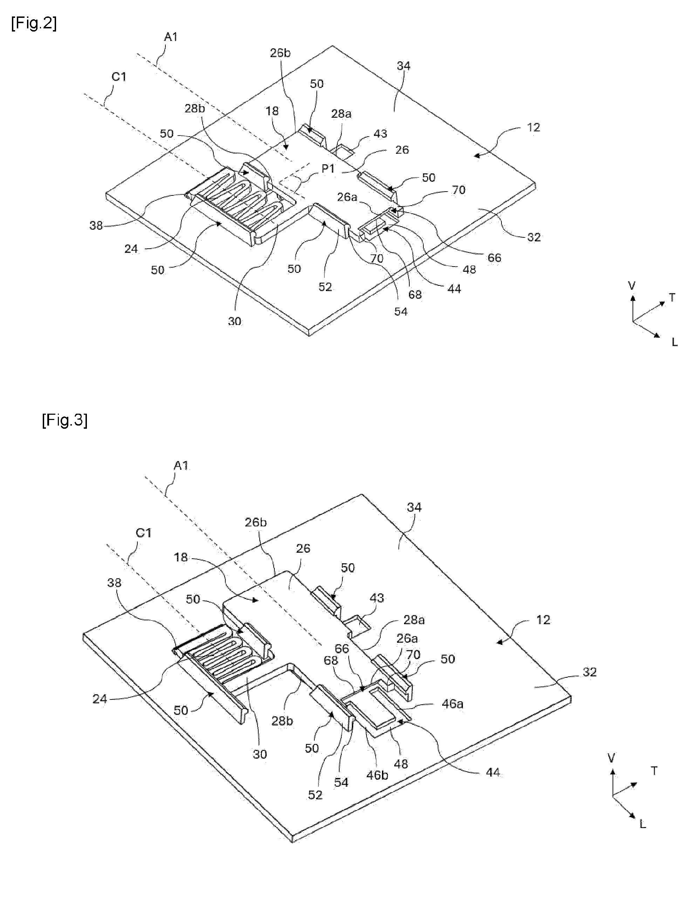

Dans la suite de la description, il convient ainsi de considérer que la paroi principale 12 et le couvercle 14 sont représentés de manière réduite et purement schématique. Aussi, la représentation de la paroi principale 12 et du couvercle 14 sur les figures ne constitue pas une forme définie et exclusive de ceux-ci. En outre, les figures 2 à 13b de la présente demande identifient une partie de la paroi principale 12 et une partie du couvercle 14 au niveau desquelles le dispositif de verrouillage 16 les solidarise l'un à l'autre.

Ainsi, la paroi principale 12 et le couvercle 14 représentés sous forme de plaques de la forme d'un quadrilatère ne sont fournis qu'à titre purement indicatif et non limitatif.

Il convient également de considérer que dans un premier temps la description s'attachera à détailler la paroi principale, le couvercle et le dispositif de verrouillage séparément, puis dans un second temps leur coopération les uns avec les autres fera l'objet d'une description détaillée.

En rapport avec l'exemple des figures 2 à 7, le dispositif de verrouillage 16 de l'ensemble de capot 10 comprend au moins un actionneur 18 et un organe de blocage 20.

Tel que particulièrement visible aux figures 2 à 5, l'actionneur 18 du dispositif de verrouillage 16 comprend au moins une nervure d'actionnement 22 et au moins un organe déformable élastiquement 24, liés en translation l'un à l'autre.

Dans l'exemple illustré et non limitatif, l'organe déformable élastiquement est un ressort 24 plat.

Tel que visible aux figures 2, 4 et 5, la nervure d'actionnement 22 s'étend en saille d'une lame 26 qui s'étend elle-même selon un axe d'allongement principal A1 longitudinal L entre une première extrémité longitudinale 26a et une deuxième extrémité longitudinale 26b.

La lame 26 présente ici la forme d'un quadrilatère dont on définit deux cotés latéraux 28a, 28b qui s'étendent longitudinalement entre la première extrémité longitudinale 26a et la deuxième extrémité longitudinale 26b de la lame 26.

Tel que visible à la figure 2, un bras de maintien 30 s'étend depuis un des côtés transversaux 28a, 28b de la lame 26, ici le deuxième côté transversal 28b, et selon un axe perpendiculaire à l'axe d'allongement principal A1 de la lame 26.

Tel que visible à la figure 2, le ressort 24 de l'actionneur 18 s'étend depuis le bras de maintien 30.

On comprend donc que la lame 26 portant la nervure d'actionnement 22 et le ressort 24 sont solidaires l'un de l'autre via le bras de maintien 30.

On définit un axe de compression C1 du ressort 24, le long duquel le ressort 24 peut commuter entre un état de compression maximum visible à la figure 3 et un état de décompression maximum, visible à la figure 2.

L'axe de compression C1 du ressort 24 est ici parallèle à l'axe d'allongement principal A1 de la lame 26.

Ainsi, la lame 26 portant la nervure d'actionnement 22 et le ressort 24 sont solidaires l'un de l'autre de telle sorte que le déplacement du ressort 24 entre son état de compression et son état de décompression le long de son axe de compression C1 entraine le déplacement de la lame 26 le long de son axe d'allongement principal A1, tel que visible aux figures 2 et 3.

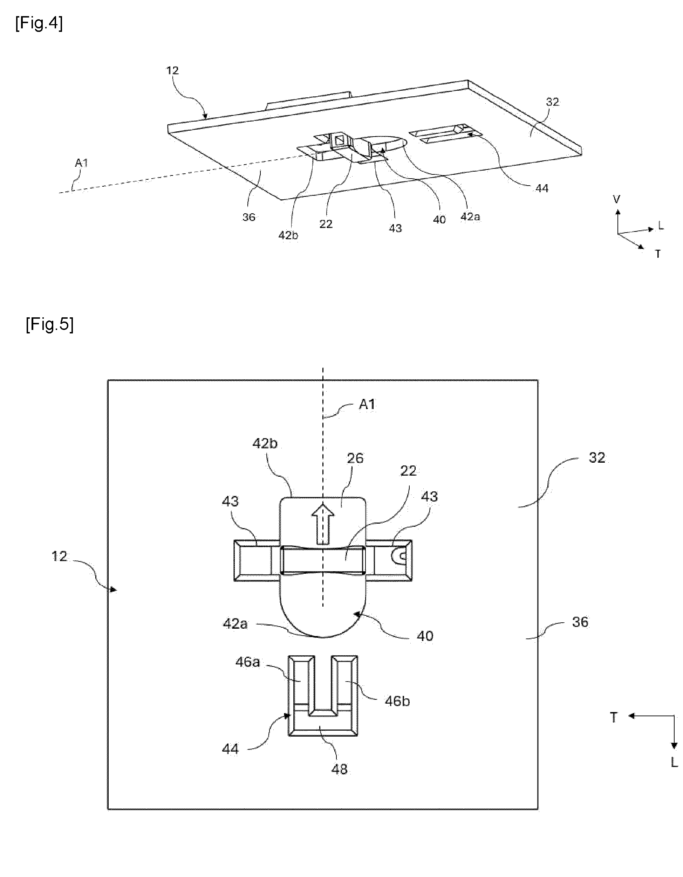

On comprend par ailleurs que la lame 26, le bras de maintien 30 et le ressort 24 s'étendent dans un plan commun P1, visible à la figure 2, qu'on définit comme longitudinal L et transversal T et que la nervure d'actionnement 22 s'étend dans un plan principal orthogonal à ce plan commun P1, tel que visible à la figure 4.

La paroi principale 12 de l'ensemble de capot 10 comprend une embase 32 plane qu'on définit comme s'étendant dans un plan principal longitudinal L et transversal T de l'embase 32.

Ici, l'axe longitudinal L est parallèle à l'axe d'allongement principal A1 de la lame 26 et de l'axe de compression C1 du ressort 24.

On définit par ailleurs une face intérieure 34 et une face extérieure 36 de l'embase 32 de la paroi principale 12, opposées l'une de l'autre selon un axe vertical V de l'embase 32.

Il convient de noter que la notion d'intérieur et d'extérieur sont à considérer lorsque la paroi principale 12 est utilisée par exemple en recouvrement d'un compteur électrique tel qu'illustré aux figures 1a et 1b, la face extérieure étant alors la face s'étendant à l'opposé du compteur électrique quand la face intérieure constitue une face invisible pour l'utilisateur, c'est-à-dire tournée vers le compteur électrique dans ces mêmes conditions.

Tel que visible à la figure 2, l'actionneur 18 est monté contre une des faces de la paroi principale 12.

Plus précisément et considérant l'exemple illustré, l'actionneur 18 est monté contre la face intérieure 34 de l'embase 32 de la paroi principale 12.

Notamment, le ressort 24 de l'actionneur 18 est solidaire de l'embase 32 via une charnière élastique 38.

La charnière élastique 38 s'étend notamment entre la face intérieure 34 de l'embase 32 et une extrémité du ressort 24 opposée selon son axe de compression C1 au bras de maintien 30.

L'utilisation et la fonction de la charnière élastique 38 seront détaillées plus loin dans la suite de la description, notamment lors de la description du procédé d'assemblage de l'ensemble de capot.

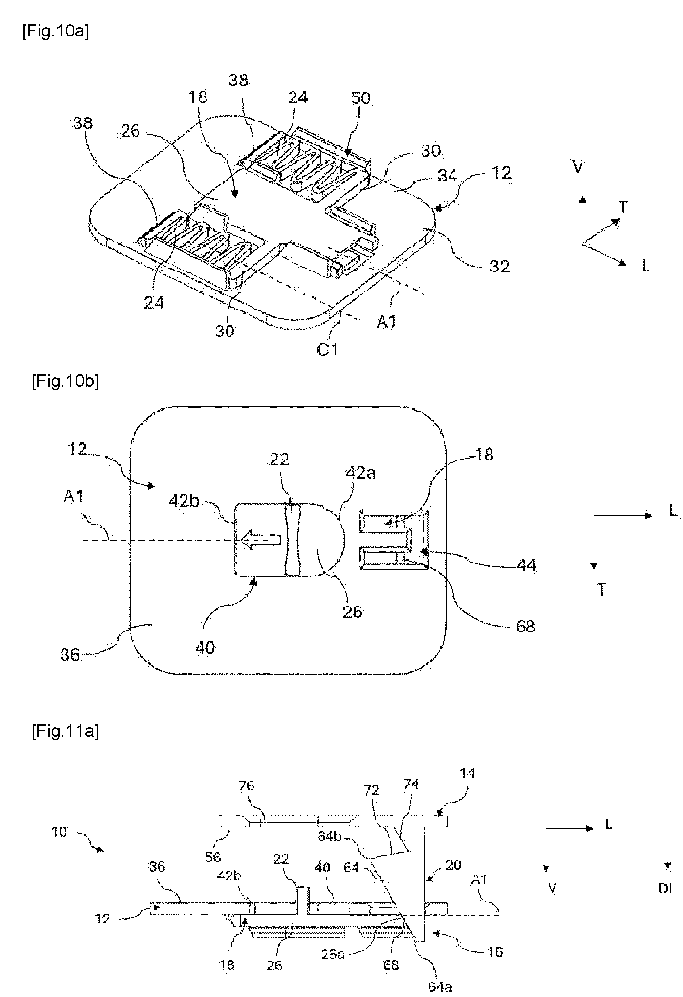

Selon un autre exemple non limitatif et visible à la figure 10a, l'actionneur 18 peut comprendre deux ressorts 24 qui s'étendent chacun depuis un bras de maintien 30 distinct.

De manière plus précise, un bras de maintien 30 s'étend perpendiculairement depuis chacun des cotés latéraux 28a, 28b de la lame 26 en étant alignés le long d'un axe transversal T.

Ainsi, chacun des deux ressorts 24 s'étend selon un axe de compression distinct, depuis l'un des bras de maintien 30 en étant relié à la face intérieure 34 par une charnière élastique 38.

Dans la suite de la description, il convient de considérer que les caractéristiques détaillées s'appliquent à l'ensemble de capot indépendamment que son actionneur comporte un ou deux ressorts.

Tel que visible aux figures 4 et 5, l'embase 32 de la paroi principale 12 comprend une lumière 40 traversante.

La lumière 40 de l'embase 32 de la paroi principale 12 s'étend principalement de long de l'axe d'allongement principal A1 de la lame 26 de l'actionneur 18 entre un premier bord 42a et un deuxième bord 42b, opposés l'un de l'autre selon l'axe d'allongement principal A1 de la lame 26.

Dans l'exemple illustré et non limitatif, le premier bord 42a de la lumière 40 présente une forme arrondie et le deuxième bord 42b de la lumière 40 présente une forme rectiligne.

L'embase 32 de la paroi principale 12 comprend également un alésage 44 traversant, distinct de la lumière 40 traversante.

Tels que visibles à la figure 5, la lumière 40 et l'alésage 44 sont alignés le long d'un axe longitudinal L de la paroi principale 12, parallèle à l'axe d'allongement principal A1 de la lame 26.

Selon l'exemple de l'invention, la lumière 40 est dimensionnée de telle sorte qu'elle soit traversée au moins en partie par la nervure d'actionnement 22 en saillie de la lame 26 de l'actionneur 18.

Dit autrement, la nervure d'actionnement 22 de l'actionneur 18 s'étend au travers de la lumière 40 formée dans l'embase 32 de la paroi principale 12.

De manière plus précise, la nervure d'actionnement 22 et la lumière 40 sont configurées de manière à permettre le déplacement en translation de la nervure d'actionnement 22 au travers de la lumière 40 selon l'état de compression et de décompression du ressort 24 évoqués précédemment.

On comprend de ce qui précède que le déplacement de la nervure d'actionnement 22 au travers de la lumière 40 de l'embase 32 s'effectue de long de l'axe d'allongement principal A1 de la lame 26 de l'actionneur 18.

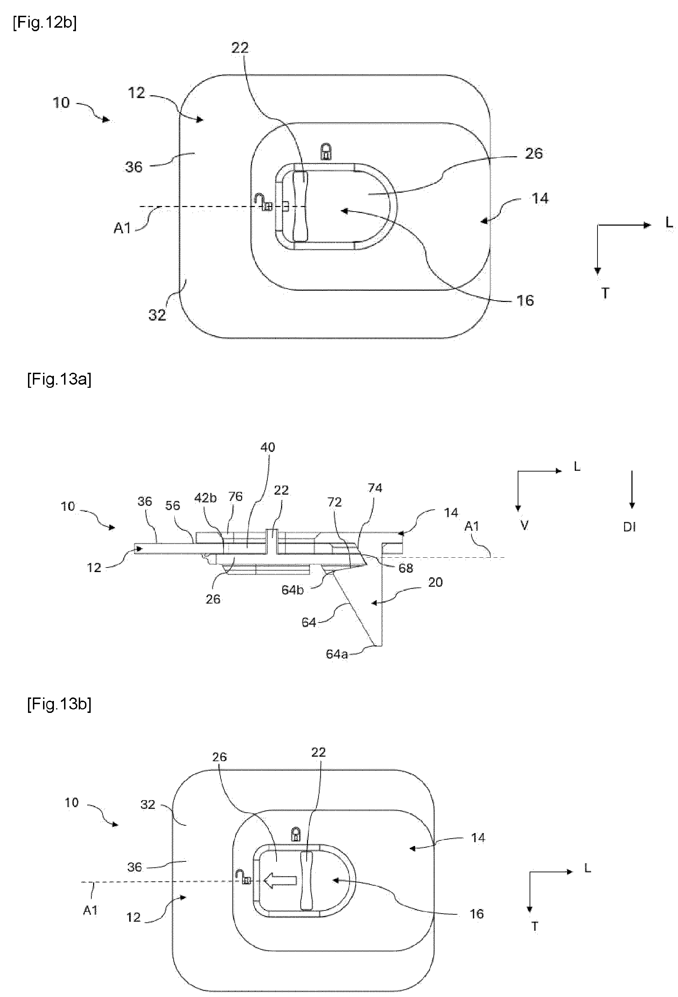

On définit alors une position de la nervure d'actionnement 22 entre une position de fermeture du dispositif de verrouillage 16, visible aux figures 2, 4 et 11b, lorsque le ressort 24 est dans son état de décompression visible à la figure 2 et une position d'ouverture du dispositif de verrouillage 16, visible à la figure 12b, lorsque le ressort 24 est dans son état de compression visible à la figure 3.

Il convient de considérer que la position de fermeture du dispositif de verrouillage 16 correspond à une position neutre dans laquelle l'actionneur 18 et plus particulièrement le ressort 24 n'est soumis à aucune contrainte extérieure.

Tel qu'illustré à la figure 10b, dans la position de fermeture du dispositif de verrouillage 16, la nervure d'actionnement 22 s'étend à une distance longitudinale non nulle du premier bord 42a et du deuxième bord 42b de la lumière 40.

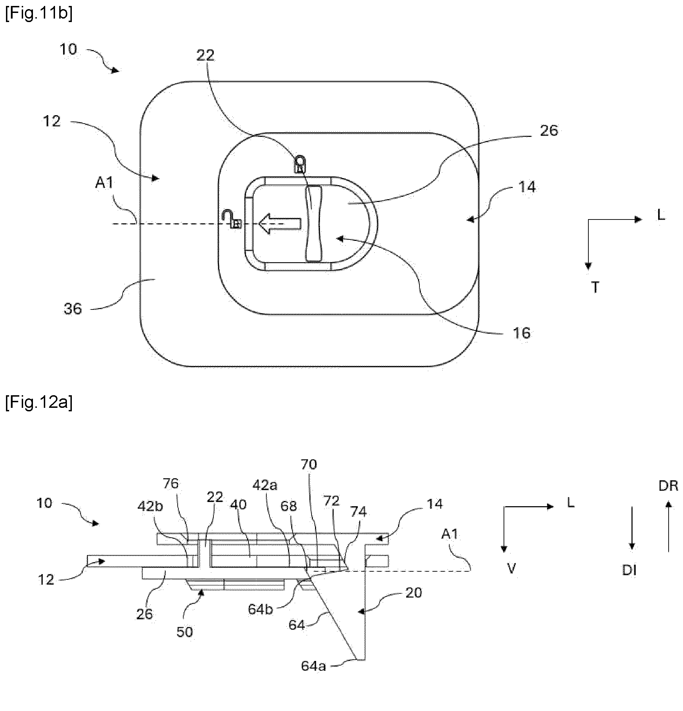

Dans la position d'ouverture du dispositif de verrouillage 16 visible aux figures 12a et 12b, la nervure d'actionnement 22 s'étend sensiblement en appui longitudinal contre le deuxième bord 42b de la lumière 40 formant alors un bord de butée.

Tel que visible à la figure 5, des orifices latéraux 43 s'étendent transversalement de part et d'autre de la lumière 40 formée dans l'embase 32.

La fonction des orifices latéraux 43 sera détaillée plus loin dans la suite de la description détaillée.

Selon l'exemple illustré et particulièrement visible à la figure 5, l'alésage 44 de l'embase 32 de la paroi principale 12 présente une forme en U.

En accord avec l'exemple illustré de l'alésage 44, on définit deux branches 46a, 46b de la forme en U reliées l'une à l'autre par une base 48 de la forme en U, et définissant la forme en U de l'alésage 44.

Tel que visible à la figure 2, dans l'état de décompression du ressort 24, correspondant à la position de la nervure d'actionnement dans laquelle le dispositif de verrouillage est dans sa position de fermeture, la lame 26 portant la nervure d'actionnement est dimensionnée de telle sorte qu'elle s'étend en recouvrement de la lumière formée dans l'embase 32 de la paroi principale 12 et en partie en recouvrement de l'alésage 44.

De manière plus précise et en accord avec l'exemple illustré de la figure 2, dans l'état de décompression du ressort 24, la lame 26 est dimensionnée de telle sorte qu'elle recouvre uniquement au moins en parties les branches 46a, 46b de la forme en U de l'alésage 44.

Par ailleurs, dans l'état de compression du ressort 24, visible à la figure 3, correspondant à la position de la nervure d'actionnement dans laquelle le dispositif de verrouillage est dans sa position d'ouverture, la lame 26 est dimensionnée de telle sorte qu'elle s'étende en recouvrement de la lumière et de manière que l'alésage 44 soit intégralement découvert de la lame 26.

Ainsi on comprend que dans l'état de compression et de décompression du ressort 24 de l'actionneur 18, la base 48 de la forme en U est découverte de la lame 26 de l'actionneur 18.

Par ailleurs, l'alésage 44 et notamment les branches 46a, 46b de sa forme en U sont positionnées et dimensionnées de telle sorte que plus le ressort 24 est compressé le long de son axe de compression C1, et plus les branches 46a, 46b de la forme en U de l'alésage 44 sont découvertes de la lame 26.

Ici, dans l'état de compression maximum du ressort 24, visible à la figure 3, les branches 46a, 46b de la forme en U de l'alésage 44 sont complétement découvertes de la lame 26.

La fonction de l'alésage 44 sera détaillée plus loin dans la suite de la description détaillée.

Tel que visible aux figures 2 et 3, l'embase 32 de la paroi principale 12 comprend des organes de maintien 50 en position de l'actionneur 18 par rapport à la paroi principale 12.

De manière plus précise, les organes de maintien 50 sont configurés pour maintenir l'actionneur 18 en recouvrement de la face intérieure 34 de l'embase 32 de la paroi principale 12 telle que décrit ci-dessus.

Tels que visibles aux figures 2 et 3, les organes de maintien 50 s'étendent en saillie verticale de la face intérieure 34 de l'embase 32.

Les organes de maintien 50 s'étendent par ailleurs selon l'axe longitudinal L de l'embase 32 de la paroi principale 12.

Les organes de maintien 50 comprennent chacun une languette 52 au bout de laquelle s'étend une surépaisseur 54 configurée pour bloquer en position l'actionneur 18 contre la face intérieure 34.

On comprend notamment que les organes de maintien 50 sont configurés de telle sorte que l'actionneur 18 soit en prise entre la face intérieure 34 de l'embase 32 et la surépaisseur 54 des organes de maintien 50.

Les surépaisseurs 54 des organes de maintien 50 forment notamment chacun un épaulement tourné vers la face intérieure 34 de l'embase 32 de la paroi principale 12 et configuré pour former une butée verticale de l'actionneur 18 en prise dans les organes de maintien 50.

Selon l'exemple illustré des figures 2 et 3, deux paires d'organes de maintien 50 s'étendent de part et d'autre de la lumière 40 et de l'alésage 44 formés dans l'embase 32 de la paroi principale 12 et de telle sorte qu'ils coopèrent avec la lame 26 de l'actionneur 18.

De manière plus précise, au moins une partie de chaque côté latéral 28a, 28b de la lame 26 est en prise verticalement entre les épaulements formés par les surépaisseurs 54 des organes de maintien 50 et la face intérieure 34 de l'embase 32 de la paroi principale 12.

Également, un organe de maintien 50 s'étend longitudinalement le long du ressort 24 et de manière à bloquer verticalement le ressort 24 entre l'épaulement formé par la surépaisseur 54 de l'organe de maintien 50 et la face intérieure 34 de l'embase 32.

On comprend alors que la languette 52 de chacun des organes de maintien 50 forme un moyen de blocage en position transversale de l'actionneur 18 et que les épaulements formés par les surépaisseurs 54 des organes de maintien 50 forment des moyens de blocage en position verticale de l'actionneur 18, par rapport à la paroi principale 12.

Par ailleurs et tel que visible aux figures 2 et 3, les organes de maintien 50 sont configurés pour autoriser le déplacement en translation de l'actionneur 18 par rapport à la paroi principale 12 selon l'état de compression et de décompression du ressort 24 évoqués précédemment.

De manière plus précise, les organes de maintien 50 disposés de part et d'autre de la lumière 40 et de l'alésage 44 sont disposés de telle sorte qu'ils forment des butées longitudinales de l'actionneur 18 lors de son déplacement en translation selon l'axe d'allongement principal A1 de la lame 26.

De manière encore plus précise, les organes de maintien 50 s'étendent de telle sorte qu'au moins un des organes de maintien 50 forme une butée longitudinale de compression maximum du ressort 24 telle que visible à la figure 3 et qu'au moins un autre organe de maintien 50 forme une butée longitudinale de décompression maximum du ressort 24 telle que visible à la figure 2.

Les organes de maintien 50 forment donc à la fois des moyens de blocage en position transversal et vertical de l'actionneur 18 par rapport à l'embase 32 de la paroi principale 12, tout en autorisant et guidant le déplacement en translation de l'actionneur 18 selon l'axe longitudinal L de l'embase 32 de la paroi principale 12 et la compression et décompression maximums du ou des ressort(s) 24.

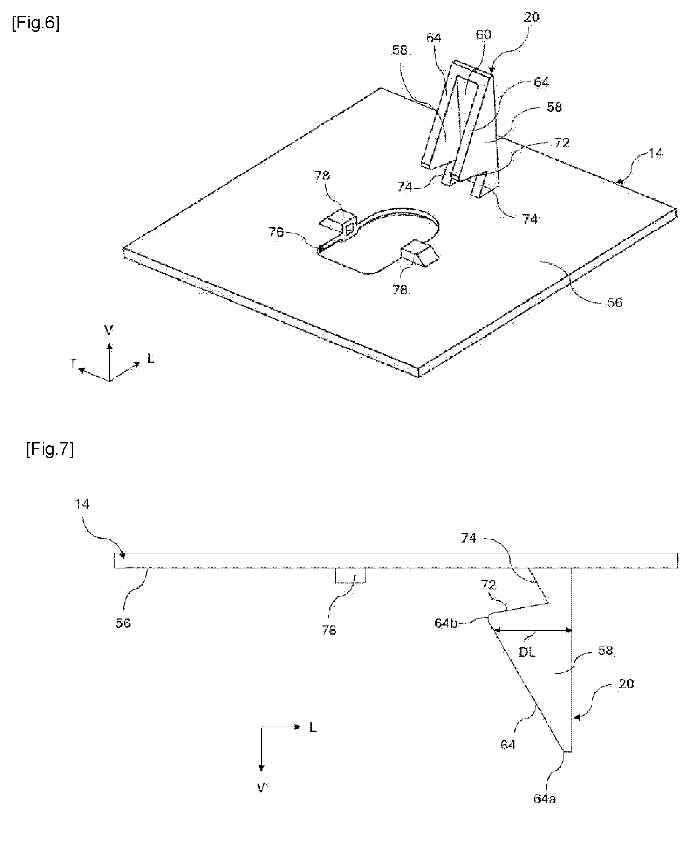

Tel que visible à la figure 6, l'ensemble de capot 10 comprend également l'organe de blocage 20 formé sur le couvercle 14.

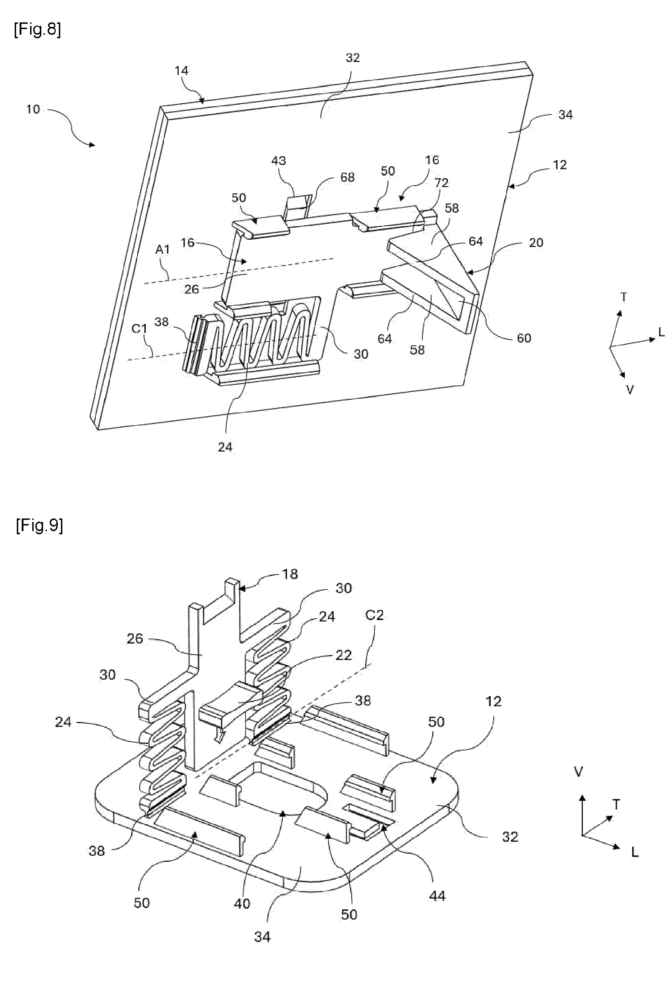

L'organe de blocage 20 s'étend notamment en saillie depuis une face de contact 56 du couvercle 14, la face de contact 56 étant destinée à être en contact de la face extérieure 36 de la paroi principale 12 dans une position d'assemblage de l'ensemble de capot 10, tel que visible à la figure 8.

Il convient de considérer que les axes longitudinal L, transversal T et vertical V de la paroi principale 12 et du couvercle 14 sont confondus lorsque ceux-ci sont assemblés via le dispositif de verrouillage 16.

L'organe de blocage 20 comprend ici et de manière non limitative deux parois verticales 58 qui s'étendent chacune dans un plan vertical V et longitudinal L distinct, depuis la face de contact 56 du couvercle 14 et en regard l'une de l'autre selon un axe transversal T.

Ainsi, les deux parois verticales 58 s'étendent à une distance non nulle l'une de l'autre considérant un axe transversal T du couvercle 14.

Les deux parois verticales 58 sont par ailleurs reliées l'une à l'autre par une paroi de liaison 60 qui s'étend depuis la face de contact 56 du couvercle 14, dans un plan vertical V et transversal T.

On comprend alors que la paroi de liaison 60 et les parois verticales 58 de l'organe de blocage 20 présentent une disposition en U en projection verticale sur un plan longitudinal L et transversal T de l'organe de blocage 20.

Ainsi et selon l'exemple illustré, l'organe de blocage 20 et l'alésage 44 présente une forme complémentaire en U en section longitudinale L et transversale T.

Une telle complémentarité de forme entre l'organe de blocage 20 et l'alésage 44 permet à l'organe de blocage 20 de s'insérer dans la paroi principale 12, au niveau de l'alésage 44 suivant une direction d'insertion DI verticale V, visible aux figures 11 à 13.

Lors d'une telle insertion de l'organe de blocage 20, on comprend que la paroi de liaison 60 s'insère dans la base 48 de la forme en U de l'alésage 44 et que chacune des parois verticales 58 s'insère dans une des branches 46a, 46b de la forme en U de l'alésage 44.

Tel que particulièrement visible aux figures 6 et 7, chacune des parois verticales 58 de l'organe de blocage 20 comprend une tranche de guidage 64 qui s'étend dans un plan sécant du plan longitudinal L et transversal T dans lequel s'étend le couvercle 14.

La tranche de guidage 64 de chacune des parois verticales 58 s'étend à l'opposé de la paroi de liaison 60, considérant l'axe longitudinal L.

On définit notamment une extrémité supérieure 64a de chacune des tranches de guidage 64 et une extrémité inférieure 64b de chacune des tranches de guidage 64, les extrémités supérieures 64a étant les plus éloignées du couvercle 14.

De manière plus précise et visible à la figure 7, chacune des tranches de guidage 64 s'étend de manière qu'une dimension longitudinale DL de chacune des parois verticales 58 augmente depuis son extrémité supérieure 64a vers son extrémité inférieure 64b.

Tel que visible à la figure 11a, les tranches de guidage 64 sont configurées pour entrer en contact avec la première extrémité longitudinale 26a de la lame 26 lors de l'insertion de l'organe de blocage 20 dans l'alésage 44 suivant la direction d'insertion DI, lorsque le dispositif de verrouillage 16 est dans sa position de fermeture, c'est-à-dire dans l'état de décompression du ressort 24.

Les tranches de guidage 64 des parois verticales 58 de l'organe de blocage 20 sont ainsi inclinées de telle sorte qu'au fur et à mesure de l'insertion de l'organe de blocage 20 dans l'alésage 44 suivant la direction d'insertion DI, les tranches de guidage 64 forment une zone de guidage inclinée qui vont déplacer la lame 26 transversalement le long de son axe d'allongement principal A1, de telle sorte que le ressort 24 se déplace de son état décompressé vers son état compressé.

Tel que visible aux figures 2, 3 et 11a, la première extrémité longitudinale 26a de la lame 26 comprend un renfoncement 66 longitudinal délimitant une zone de réception de l'organe de blocage 20.

De manière plus précise, le renfoncement 66 de la première extrémité longitudinale 26a de la lame 26 est délimité au moins par un bord biseauté 68 destiné à entrer en contact avec les tranches de guidage 64 des parois verticales 58 de l'organe de blocage 20 lors de l'insertion de ce dernier dans l'alésage 44.

Ainsi et tel que visible à la figure 11a, le bord biseauté 68 du renfoncement 66 de la première extrémité longitudinale 26a de la lame 26 présente une inclinaison selon un plan sécant du plan commun dans lequel s'étend l'actionneur 18 de telle sorte à présenter une complémentarité d'inclinaison avec le plan incliné des tranches de guidage 64 des parois verticales 58.

Dit autrement, le bord biseauté 68 de la première extrémité longitudinale 26a de la lame 26 et les tranches de guidage 64 s'étendent dans des plans inclinés parallèles l'un de l'autre.

On garantit ainsi un contact plan entre le bord incliné 68 et les tranches de guidage 64 de manière à faciliter le déplacement en translation de la lame 26 selon son axe d'allongement principal A1 et ainsi la compression du ressort 24.

Tel que visible aux figures 2 et 3, le renfoncement 66 de la première extrémité longitudinale 26a de la lame 26 est configuré de telle sorte que subsistes des appendices de guidage latéraux 70 qui s'étendent longitudinalement de part et d'autre du bord biseauté 68.

Les appendices de guidages latéraux 70 s'étendent de manière à encadrer latéralement les parois verticales 58 de l'organe de blocage 20 pendant et après son insertion dans l'alésage 44.

Les appendices de guidages latéraux 70 permettent entre autres d'améliorer la stabilité de la position de l'organe de blocage 20 au travers de l'alésage 44 en limitant les effets de basculement.

Tel que visible aux figures 6 et 7, les parois verticales 58 comprennent chacune une tranche de retenue 72 et une tranche de contact 74.

Notamment, la tranche de contact 74 de chacune des parois verticales 58 s'étend depuis la face de contact 56 du couvercle 14 puis est prolongée par la tranche de retenue 72, elle-même prolongée par la tranche de guidage 64.

La tranche de contact 74 de chacune des parois verticales 58 s'étend dans un plan parallèle au plan de la tranche de guidage 64.

On comprend alors que la tranche de contact 74 s'étend dans un plan d'inclinaison complémentaire avec le bord biseauté 68 du renfoncement 66 de la première extrémité longitudinale 26a de la lame 26, tel qu'évoqué précédemment.

La tranche de contact 74 de chacune des parois verticales 58 est ainsi configurée pour former une butée longitudinale de la première extrémité longitudinale 26a de la lame 26 lorsque le couvercle 14 est assemblé avec la paroi principale 12 et que la nervure d'actionnement 22 est dans la position de fermeture du dispositif de verrouillage 16, tel que visible à la figure 13a.

Dit autrement, dans la position de fermeture du dispositif de verrouillage 16, lorsque le ressort 24 est dans son état de décompression maximum et que le couvercle 14 est monté sur la paroi principale 12 tel que visible à la figure 13a, le bord biseauté 68 de la première extrémité longitudinale 26a de la lame 26 est en contact plan avec la tranche de contact 74 de chacune des parois verticales 58 de l'organe de blocage 20.

Par ailleurs et tel que visible à la figure 7, la tranche de retenue 72 s'étend dans un plan sécant des plans de la tranche de guidage 64 et de la tranche de contact 74 et de telle sorte qu'elle forme une rampe de guidage du bord biseauté 68 de la première extrémité longitudinale 26a de la lame 26, vers la tranche de contact 74.

Dit autrement, la tranche de retenue 72 de chacune des parois verticales 58 s'étend depuis l'extrémité inférieure 64b de la tranche de guidage 64 vers la tranche de contact 74 et de telle sorte qu'elle génère une pente positive dans un plan longitudinal L et vertical V de l'organe de blocage 20 depuis l'extrémité inférieure 64b vers la tranche de contact 74.

Ainsi, durant l'insertion de l'organe de blocage 20 dans l'alésage 44, lorsque les tranches de guidage 64 des parois verticales 58 ont déplacées la nervure d'actionnement 22 dans la position d'ouverture du dispositif de verrouillage tel que visible aux figures 12a et 12b, l'inclinaison positive de la tranche de retenue 72 permet d'une part de faciliter le retour élastique du ressort 24 de manière à déplacer la lame 26 portant la nervure d'actionnement 22 dans la position de fermeture du dispositif de verrouillage, et d'autre part d'améliorer le plaquage du couvercle 14 contre la paroi principale 12.

Notamment, l'inclinaison de la tranche de retenue 72 permet de déplacer automatiquement le couvercle 14 verticalement vers l'embase 32 de la paroi principale lors du retour élastique du ressort 24 de sa position compressée visible à la figure 12a vers sa position décompressée visible à la figure 13a.

En d'autres termes, on garantit le contact entre la face extérieure 36 de l'embase 32 de la paroi principale 12 et la face de contact 56 du couvercle 14, tel que visible à la figure 13a.

On comprend alors que lorsque le dispositif de verrouillage 16 est dans sa position de fermeture avec l'organe de blocage 20 inséré dans l'alésage 44 tel que visible aux figures 8, 13a et 13b, la lame 26 s'étend en recouvrement de la tranche de retenue 72 et de manière que son bord biseauté 68 soit en contact plan avec la tranche de contact 74 des parois verticales 58.

On comprend que lorsque le bord biseauté 68 de la première extrémité longitudinale 26a de la lame 26 est au contact de la tranche de contact 74, l'organe de blocage 20 est bloqué verticalement en position, par la tranche de retenue 72 bloquée par la lame 26.

Tel que visible à la figure 6, le couvercle 14 comprend une lumière complémentaire 76 configurée pour s'étendre en regard de la lumière de l'embase de la paroi principale lorsque le couvercle 14 est assemblé avec la paroi principale.

La lumière complémentaire 76 comprend alors une complémentarité de forme avec la lumière 40.

On comprend alors que lorsque le couvercle 14 est assemblé avec la paroi principale, la nervure d'actionnement 22 s'étend également au travers de la lumière complémentaire 76 de manière à être accessible pour un utilisateur.

Le couvercle 14 comprend par ailleurs deux ergots 78 faisant saillie de la face de contact 56 de part et d'autre de la lumière complémentaire 76 et manière qu'ils coopèrent avec les orifices latéraux 43 de l'embase 32 visibles à la figure 5.

Les ergots 78 peuvent alors comprendre un passage pour un dispositif de scellage du dispositif de verrouillage, non représenté ici.

Il convient par ailleurs de considérer que l'utilisation du dispositif de scellage est optionnelle. Ainsi, dans le cas où l'utilisation d'un dispositif de scellage n'est pas requise, l'ensemble de capot est dépourvu d'orifices latéraux et d'ergots tels que décrits ci-dessus.

Tel que visible aux figures 1a et 1b, l'embase 32 de la paroi principale 12 peut être formée dans un renfoncement de la paroi principale 12 de forme complémentaire avec le couvercle 14.

Dit autrement, le renforcement formant l'embase 32 de la paroi principale 12 permet de recevoir le couvercle 14 de manière que leur coopération génère une surface plane, sans surépaisseur formée par la superposition du couvercle 14.

Un procédé d'assemblage de l'ensemble de capot 10 va maintenant être décrit en rapport avec les figures 9 à 13b.

Il convient de considérer que le procédé d'assemblage est décrit avec l'ensemble de capot 10 dont l'actionneur 18 comprend deux ressorts 24 mais que le même procédé d'assemblage s'applique à un actionneur 18 comprenant un unique ressort 24.

Selon un mode de réalisation préféré, l'ensemble de capot 10 est obtenu par un procédé d'injection.

Aussi, la figure 9 illustre la paroi principale 12 portant l'actionneur 18 à l'issue de l'opération d'injection dans lequel l'actionneur 18 est dans une position relevée par rapport à l'embase 32 de la paroi principale 12.

Notamment, les ressorts 24 sont solidaires de l'embase 32 au moyen des charnières élastiques 38 décrites précédemment.

Ainsi, préalablement à l'assemblage de l'ensemble de capot 10, une étape préparatoire est nécessaire.

De manière plus précise, l'étape préparatoire est réalisée directement en usine à l'issue de la réalisation de la paroi principale 12 par injection.

L'étape préparatoire consiste notamment au pivotement de l'actionneur 18 autour d'un axe de charnière C2, ici transversal T, de telle sorte à déplacer l'actionneur 18 contre l'embase 32 de la paroi principale 12.

De manière plus précise, lors de l'étape préparatoire, l'actionneur 18 est pivoté de telle sorte que la nervure d'actionnement 22 s'étende au travers de la lumière 40 de l'embase 32 et que l'actionneur 18 soit bloqué en position contre l'embase 32 au moyen des organes de maintien 50, tel que décrit précédemment.

Dit autrement, l'étape préparatoire consiste en un clipsage de l'actionneur 18 contre l'embase 32 de la paroi principale 12 au moyen des organes de maintien 50.

A l'issu de l'étape préparatoire, on comprend que la nervure d'actionnement 22 s'étend au travers de la lumière 40 dans la position de fermeture du dispositif de verrouillage 16 et que les ressorts 24 sont dans leur position de décompression, tels que visibles aux figures 10a et 10b.

Une fois l'étape préparatoire réalisée, une première étape du procédé d'assemblage visible à la figure 11a est mise en œuvre durant laquelle un utilisateur insère l'organe de blocage 20 porté par le couvercle 14 dans l'alésage 44 de l'embase 32, en exerçant une force suivant la direction d'insertion DI.

Lors de cette première étape, la paroi de liaison est positionnée en regard de la base 48 de la forme en U de l'alésage 44 et les parois verticales 58 se situent en regard des branches de la forme en U de l'alésage 44.

Également, les ergots 78 sont positionnés en regard des orifices latéraux 43.

On comprend de ce qui précède que lors de l'insertion de l'organe de blocage 20 dans l'alésage 44, les tranches de guidage 64 entrent en contact avec le bord biseauté 68 de la lame 26.

Ainsi, au fur et à mesure de l'insertion de l'organe de blocage 20 dans l'alésage 44 selon la direction d'insertion DI, tel que visible à la figure 11a, la lame 26 est déplacée le long de son axe d'allongement principal A1 et de telle sorte que les ressorts se compressent progressivement le long de leur axe de compression respectif.

Tel que visible à la figure 12a, lorsque l'organe de blocage 20 est inséré dans l'alésage 44 de telle sorte que le bord biseauté 67 est au niveau de l'extrémité inférieure 64b de la tranche de guidage 64, la nervure d'actionnement 22 arrive en fin de course et est dans la position d'ouverture du dispositif de verrouillage 16, tel que visible à la figure 12b, et les ressorts sont dans leur état de compression maximum.

Une deuxième étape du procédé est mise en œuvre.

Notamment, la deuxième étape consiste en un déplacement automatique de la lame 26 lorsque son bord biseauté 68 dépasse l'extrémité inférieure 64b de la tranche de guidage 64, de manière que la nervure d'actionnement 22 se déplace automatiquement dans la position de fermeture du dispositif de verrouillage 16, tel que visible à la figure 13a.

De manière plus précise, sous l'effet de retour élastique des ressorts dans leur état décompressé et au moyen des tranches de retenue 72 des parois verticales 58 formant des rampes de guidage du bord biseauté 68 de la lame 26, la nervure d'actionnement 22 se déplace automatique dans la position de fermeture du dispositif de verrouillage 16.

En d'autres termes, lorsque l'organe de blocage 20 est inséré dans l'alésage 44 de telle sorte que le bord biseauté 68 de la lame 26 dépasse l'extrémité inférieure 64b des tranches de guidage 24, l'inclinaison des tranches de retenue 72 combinée à l'effet de retour élastique des ressorts 24 vers leur état de décompression amène automatique la nervure d'actionnement 22 dans l'état de fermeture du dispositif de verrouillage 16 par glissement du bord biseauté 68 contre les tranches de retenue 72.

Tel qu'évoqué précédemment, durant la deuxième étape, la face de contact 56 du couvercle 14 est plaquée contre la face extérieure 36 de l'embase 32 de la paroi principale 12.

On comprend qu'à l'issue de la deuxième étape le bord biseauté 68 translate le long de la tranche de retenue 72 jusqu'à venir en contact plan avec la tranche de contact 74, et tel que visible à la figure 13a.

A l'issue de la deuxième étape et tel que visible aux figures 13a et 13b, la nervure d'actionnement 22 est dans la position de fermeture du dispositif de verrouillage 16 de telle sorte que la lame 26, dont le bord biseauté 68 est au contact de la tranche de contact 74, maintien l'organe de blocage 20 dans l'alésage 44 en formant une butée verticale des tranches de retenue 72.

Autrement dit, à l'issue de la deuxième étape le couvercle 14 est bloqué en position sur la paroi principale 12 au moyen du dispositif de verrouillage 16 dans sa position de fermeture.

Dans le cas où l'utilisateur souhaite déverrouiller le dispositif de verrouillage 16 afin de désolidariser le couvercle 14 de la paroi principale 12, par exemple pour une opération de maintenance de l'installation de compteur électrique, une troisième étape peut être mise en œuvre.

Au cours de la troisième étape, l'utilisateur déplace la nervure d'actionnement 22 contre le deuxième bord 42b de la lumière 40, tel que visible à la figure 12b, de telle sorte à compresser les ressorts et positionner le dispositif de verrouillage 16 dans sa position d'ouverture.

On comprend qu'a l'issue de la troisième étape, la lame 26 est déplacée en translation le long de son axe d'allongement principal A1 et de manière que le bord biseauté 68 s'éloigne longitudinalement de la tranche de contact 74.

Ainsi et tel que visible à la figure 12a, à l'issue de la troisième étape le dispositif de verrouillage 16 est dans sa position d'ouverture et la tranche de retenue 72 est découverte de la lame 26.

De la sorte, à l'issue de la troisième étape l'utilisateur peut librement retirer le couvercle 14 selon une direction de retrait DR, opposée à la direction d'insertion DI, tout en continuant à maintenir la nervure d'actionnement 22 dans l'état de déverrouillage du dispositif de verrouillage 16.

Une fois l'organe de blocage 20 retiré de l'alésage 44, l'utilisateur peut relâcher la nervure d'actionnement 22 de manière que le retour élastique des ressorts 24 ramène la nervure d'actionnement 22 dans la position de fermeture du dispositif de verrouillage 16 et de décompression des ressorts, tels que visibles aux figures 10a et 10b.

On comprend qu'à l'issue de la quatrième étape, l'utilisateur peut remettre en œuvre la deuxième étape du procédé, par exemple pour repositionner le couvercle 14 sur la paroi principale 12 après son opération de maintenance de l'installation de compteur électrique.

On tire ainsi avantage de l'invention telle qu'elle vient d'être décrite en ce qu'elle permet de solidariser de manière simple un couvercle sur une paroi principale sans nécessiter l'utilisation d'une pièce tierce telle qu'une vis, tout en permettant une désolidarisation et solidarisation au moins en partie automatique. De plus, l'invention permet de solidariser et désolidariser un couvercle sur une paroi principale sans nécessiter l'utilisation d'outils tels que par exemple un tournevis.

De plus, l'invention telle qu'elle vient d'être décrite est avantageuse en ce qu'elle permet de solidariser deux pièces obtenues par injection plastique, l'une à l'autre sans nécessiter de pièce tierce et dont le procédé d'assemblage et de désassemblage peut être réalisé d'une seule main par un utilisateur.

## Revendications

1. Ensemble de capot (10) comprenant une paroi principale (12) et un couvercle (14), aptes à coopérer l'un avec l'autre, l'ensemble de capot (10) comprenant un dispositif de verrouillage (16) configuré pour bloquer en position le couvercle (14) sur la paroi principale (12), le dispositif de verrouillage (16) comprenant au moins :
- Un actionneur (18) sur la paroi principale (12) et comprenant au moins une nervure d'actionnement (22) et au moins un organe déformable élastiquement (24) liés en translation l'un à l'autre, la nervure d'actionnement (22) s'étendant au travers d'une lumière (40) traversante formée dans la paroi principale (12), et l'actionneur (18) étant mobile en translation par rapport à la paroi principale (12) de manière que la nervure d'actionnement (22) se déplace au travers de la lumière (40) entre une position de fermeture du dispositif de verrouillage (16) dans laquelle l'organe déformable élastiquement (24) est dans un état de décompression, et une position d'ouverture du dispositif de verrouillage (16) dans laquelle l'organe déformable élastiquement (24) est dans un état de compression,
- Un organe de blocage (20) s'étendant en saillie depuis le couvercle (14) et configuré au moins pour bloquer en position ledit couvercle (14) par rapport à la paroi principale (12) lorsque la nervure d'actionnement (22) de l'actionneur (18) est dans la position de fermeture du dispositif de verrouillage (16).

2. Ensemble de capot (10) selon la revendication précédente, dans lequel l'actionneur (18) comprend une lame (26) depuis laquelle la nervure d'actionnement (22) s'étend en saillie, la lame (26) étant solidaire de l'organe déformable élastiquement (24) par au moins un bras de maintien (30) s'étendant transversalement depuis la lame (26), le ressort étant solidaire du bras de maintien (30).

3. Ensemble de capot (10) selon l'une quelconque des revendications précédentes, dans lequel au moins deux organes de maintien (50) s'étendent en saillie depuis la paroi principale (12) et de manière à bloquer en position l'actionneur (18) contre la paroi principale (12) et de manière à autoriser le déplacement en translation de l'actionneur (18) par rapport à la paroi principale (12).

4. Ensemble de capot (10) selon l'une quelconque des revendications précédentes, dans lequel la paroi principale (12) comprend un alésage (44) traversant configuré de manière à recevoir l'organe de blocage (20).

5. Ensemble de capot (10) selon la revendication précédente, dans lequel l'organe de blocage (20) comprend au moins une tranche de guidage (64) s'étendant dans un plan sécant d'un plan commun (P1) de l'actionneur (18), l'au moins une tranche de guidage (64) étant configurée pour déplacer la nervure d'actionnement (22) depuis la position de fermeture du dispositif de verrouillage (16) vers la position d'ouverture du dispositif de verrouillage (16) lors de l'insertion de l'organe de blocage (20) dans l'alésage (44).

6. Ensemble de capot (10) selon la revendication précédente, dans lequel l'organe de blocage (20) comprend au moins une tranche de retenue (72) configurée pour déplacer automatiquement la nervure d'actionnement (22) depuis la position d'ouverture du dispositif de verrouillage (16) vers la position de fermeture du dispositif de verrouillage (16) lors de l'insertion de l'organe de blocage (20) dans l'alésage (44), de manière à bloquer en position le couvercle (14) par rapport à la paroi principale (12).

7. Ensemble de capot (10) selon l'une quelconque des revendications précédentes en combinaison avec la revendication 2, dans laquelle la lame (26) comprend un bord biseauté (68) configuré pour être en contact plan avec l'au moins une tranche de guidage (64) de l'organe de blocage (20) lors de l'insertion de l'organe de blocage (20) dans l'alésage (44).

8. Ensemble de capot (10) selon la revendication précédente, dans lequel l'organe de blocage (20) comprend au moins une tranche de contact (74) configurée pour être en contact plan avec le bord biseauté (68) de la lame (26) lorsque l'organe de blocage (20) est inséré dans l'alésage (44) et que la nervure d'actionnement (22) est dans la position de fermeture du dispositif de verrouillage (16).

9. Ensemble de capot (10) selon l'une quelconque des revendications précédentes, dans lequel le couvercle (14) comprend une lumière complémentaire (76) configurée pour s'étendre en regard de la lumière (40) de la paroi principale (12) lorsque le couvercle (14) est assemblé sur la paroi principale (12) et de manière que la nervure d'actionnement (22) s'étende au travers de la lumière complémentaire (76).

10. Ensemble de capot (10) selon l'une quelconque des revendications précédentes, dans lequel l'actionneur (18) est monté pivotant par rapport à la paroi principale (12) au moyen d'au moins une charnière élastique (38) s'étendant entre l'au moins un organe déformable élastiquement (24) et la paroi principale (12), et de manière que l'actionneur (18) soit apte à pivoter autour d'un axe de charnière (C2) par rapport à la paroi principale (12).

11. Ensemble de capot (10) selon l'une quelconque des revendications précédentes, dans lequel l'actionneur (18) est monobloc avec la paroi principale (12) et l'organe de blocage (20) est monobloc avec le couvercle (14).

12. Ensemble de capot (10) selon l'une quelconque des revendications précédentes, obtenu par un procédé d'injection plastique.

13. Installation de compteur électrique (200) comprenant un compteur électrique est au moins un ensemble de capot (10) selon l'une quelconque des revendications précédentes.
